# EUROPEAN PATENT APPLICATION

(11) **EP 4 411 479 A1**
(43) Date of publication of application: **07.08.2024**
(21) Application number: 22876139.1
(22) Date of filing: 26.09.2022
(51) Int. Cl.: G03F 7/095, B41N 1/00, G03F 7/00, G03F 7/004, G03F 7/032, G03F 7/035, G03F 7/037

(54) **PRINTING ORIGINAL PLATE FOR PHOTOSENSITIVE RESIN LETTERPRESS, AND PRINTING PLATE**

(30) Priority: 30.09.2021 JP 2021161267
(71) Applicant: TOYOBO MC Corporation, Osaka 530-0001 (JP)
(72) Inventor: TANIGAWA, Masahito, Okayama-shi, Okayama 704-8194 (JP); IWASHITA, Yuji, Otsu-shi, Shiga 520-0292 (JP)
(74) Representative: Müller-Boré & Partner Patentanwälte PartG mbB
(86) International application number: PCT/JP2022/035756
(87) International publication number: WO 2023/054272

(57) **Abstract**

The present invention provides a photosensitive resin printing plate precursor for relief printing that can achieve both gradation print reproducibility of a highlight part and plate life, and that has a low plate-surface adhesiveness.

A photosensitive resin printing plate precursor for relief printing, wherein the photosensitive resin printing plate precursor comprises a support, a photosensitive resin layer, and a cover film stacked in this order, wherein the photosensitive resin layer comprises a lower layer present on a support side and an upper layer present on a cover-film side, wherein the upper layer is a photosensitive resin layer that contains a water-soluble or water-dispersible resin (A) having a glass transition temperature measured by differential scanning calorimeter of 40 to 90°C, wherein the upper layer has a thickness of 3 to 30 micrometers, wherein the lower layer is a layer that contains a water-soluble or water-dispersible resin (B) having a glass transition temperature higher than the glass transition temperature of the water-soluble or water-dispersible resin (A) by 5°C or more, and wherein the glass transition temperature of the resin (B) measured by differential scanning calorimeter is 95 to 135°C.

## Description

### Technical Field

The present invention relates to a photosensitive resin printing plate precursor for relief printing, and printing plate.

### Background Art

Normally, a photosensitive resin composition used for a printing plate generally contains a soluble polymer compound, a photopolymerizable unsaturated compound, and a photopolymerization initiator, and has additives such as a stabilizer and a plasticizer blended therein as necessary.

Conventionally widely known is making a relief plate for printing by a plate making step of applying an active light beam to this photosensitive resin composition layer through a negative film including a transparent image part, to cure the photosensitive layer of an exposed portion, then dissolving and removing the photosensitive layer of an unexposed portion with an appropriate solvent, and subjecting the resulting plate to drying and post exposure.

As to the soluble polymer compound of the photosensitive resin composition, the use of a soluble polyamide, a completely or partially saponified polyvinyl acetate, or the like has been proposed.

Recently, users are increasingly requiring an ultrafine-pattern reproduction of a relief printing plate precursor. Accordingly, as to a minimum highlight part used in printing of a picture, 5% or less halftone dots formed at 200 lpi of screen-ruling are required to have reproducibility of smoothly changing brightness in a printing size close to the size of the negative (gradation expression of halftone dots in a highlight part).

As to a conventional technique for addressing such a requirement of fine printability of halftone dots in a highlight part, there are, for example, a relief printing plate precursor that has a multilayer structure including photosensitive resin layers having different light transmissivities and has thereby improved image reproducibility (see Patent Document 1), and a relief printing plate precursor having a sharp relief shape achieved by forming multiple photosensitive resin layers (see Patent Document 2). None of the relief printing plate precursors, however, sufficiently satisfies the gradation expression of halftone dots in a highlight part.

In addition, a relief printing plate often causes a problem of generating a crack thereon during printing, and generating defective printed matter due to the crack. Proposed in order to improve this plate life is a method of using partially saponified PVA and a polyamide compound in combination with a specific crosslinking agent (see Patent Document 3), and a method of using a polyamide obtained by copolymerizing an alicyclic dicarboxylic acid with an alicyclic diamine (see Patent Document 4).

### Prior Art Documents

### Patent Documents

Patent Document 1: Japanese Patent Application Laid-Open (JP-A) No. 2002-23349
Patent Document 2: Japanese Patent Application Laid-Open (JP-A) No. 313966/94
Patent Document 3: Japanese Patent Application Laid-Open (JP-A) No. 2014-142622
Patent Document 4: WO 17/056692

### Disclosure of the Invention

### Problem that the Invention is to Solve

The present invention has been made in view of the present situation of the conventional technique described above. An object of the present invention is to provide a photosensitive resin printing plate precursor for relief printing, and printing plate that can each achieve both gradation print reproducibility of a highlight part and high-level plate life, to further provide a photosensitive resin printing plate precursor for relief printing, and a printing plate that each have a low plate-surface adhesiveness. In further detail, the object is to provide a photosensitive resin printing plate precursor for relief printing, and a printing plate that are each less likely to generate a crack even when subjected to printing under a high printing pressure, such printing having not been achieved by the printing plate precursors of the conventional technique, that enable printing of more copies, and that have a low plate-surface adhesiveness.

### Means for Solving the Problem

In order to achieve the object, the inventors of the present invention have earnestly studied a resin used in a photosensitive resin composition of a relief printing plate precursor, and a structure of the printing plate precursor. As a result of the study, the inventors have found that it is possible to achieve both gradation print reproducibility of a highlight part and high-level plate life by making a photosensitive resin layer have a structure including a lower layer present on a support side and an upper layer present on a cover-film side, and setting the thickness of the upper layer in the photosensitive resin layer and the glass transition temperatures of resins used in the upper layer and the lower layer to specific ranges. Thus, the present invention has been completed.

That is, the present invention can include the following (1) to (3) configurations.
(1) A photosensitive resin printing plate precursor for relief printing, wherein the photosensitive resin printing plate precursor comprises a support, a photosensitive resin layer, and a cover film stacked in this order, wherein the photosensitive resin layer comprises a lower layer present on a support side and an upper layer present on a cover-film side, wherein the upper layer is a photosensitive resin layer that contains a water-soluble or water-dispersible resin (A) having a glass transition temperature measured by differential scanning calorimeter of 40 to 90°C, wherein the upper layer has a thickness of 3 to 30 micrometers, wherein the lower layer is a layer that contains a water-soluble or water-dispersible resin (B) having a glass transition temperature higher than the glass transition temperature of the water-soluble or water-dispersible resin (A) by 5°C or more, and wherein the glass transition temperature of the resin (B) measured by differential scanning calorimeter is 95 to 135°C.
(2) The photosensitive resin printing plate precursor for relief printing according to (1), wherein the resin (A) is a polyamide or a polyether urethane urea, and wherein the resin (B) is a polyamide, a polyether urethane urea, or a polyether amide.
(3) A printing plate obtained by removing an uncured portion of the photosensitive resin layer from the photosensitive resin printing plate precursor for relief printing according to (1) or (2).

### Effects of the Invention

According to the present invention, it is possible to provide a photosensitive resin printing plate precursor for relief printing, and a printing plate that can each achieve both gradation print reproducibility of a highlight part with 1 to 5% halftone dots and high-level plate life, and that further have a low plate-surface adhesiveness.

### Mode for Carrying Out the Invention

The photosensitive resin printing plate precursor for relief printing of the present invention has a structure wherein the photosensitive resin layer comprises a lower layer present on a support side and an upper layer present on a cover-film side. Preferably, the upper layer is a photosensitive resin layer that contains a water-soluble or water-dispersible resin (A) having a glass transition temperature of 40 to 90°C, the upper layer has a thickness of 3 to 30 micrometers, and the lower layer is a layer that contains a water-soluble or water-dispersible resin (B) having a glass transition temperature higher than the glass transition temperature of the water-soluble or water-dispersible resin (A) by 5°C or more. In the present description, a numerical range represented by "to" means a range including numerical values described before and after "to" as a lower-limit value and an upper-limit value, respectively.

The upper layer of the photosensitive resin layer used in the present invention has a thickness of preferably 3 micrometers or more, more preferably 5 micrometers or more, and further preferably 7 micrometers or more. The upper layer having an excessively small thickness sometimes decreases the plate life when the number of printing shots is increased. On the other hand, the upper layer has a thickness of preferably 30 micrometers or less, more preferably 20 micrometers or less, and further preferably 10 micrometers or less. The upper layer having an excessively large thickness sometimes decreases the printability of a highlight part.

The water-soluble or water-dispersible resin (B) used in the lower layer of the present invention is a resin having a glass transition temperature of 95°C or higher and 135°C or lower. The water-soluble or water-dispersible resin (B) having an excessively low glass transition temperature may possibly decrease the printability of a highlight part. The glass transition temperature of the water-soluble or water-dispersible resin (B) is preferably 95°C or higher, more preferably 105°C or higher, and further preferably 110°C or higher. The water-soluble or water-dispersible resin (B) having an excessively high glass transition temperature may possibly decrease the plate life. The glass transition temperature of the water-soluble or water-dispersible resin (B) is preferably 135°C or lower, more preferably 130°C or lower, and further preferably 125°C or lower. When setting the glass transition temperature of the water-soluble or water-dispersible resin (B) used in the lower layer to be higher than the glass transition temperature of the water-soluble or water-dispersible resin (A) by 5°C or more, the gradation print reproducibility of a highlight part becomes satisfactory.

The water-soluble or water-dispersible resin (B) is, for example, a polyamide or a polyether urethane urea, and is preferred to be a polyamide in terms of molecular design for controlling the glass transition temperature.

The polyamide of the present invention is obtained, for example, by reacting a diamine with a dicarboxylic acid.

Examples of the diamine include a diamine containing no tertiary nitrogen atom, and a tertiary nitrogen atom-containing diamine. These diamines can be used singly or in combination of two or more thereof.

Examples of the diamine containing no tertiary nitrogen atom include ethylenediamine, diethylenediamine, trimethylenediamine, tetramethylenediamine, hexamethylenediamine, 1,3-propylenediamine, 2-methylpentamethylenediamine, undecamethylenediamine, dodecamethylenediamine, 2,2,4-trimethylhexamethylenediamine, 2,4,4-trimethylhexamethylenediamine, isophoronediamine, 1,4-cyclohexanediamine, 1,3-cyclohexanediamine, 1,3-bis(aminomethyl)cyclohexane, 1,4-bis(aminomethyl)cyclohexane, 1-amino-3-aminomethyl-3,5,5-trimethylcyclohexane, bis(4-aminocyclohexyl)methane, bis(3-methyl-4-aminocyclohexyl)methane, 2,2-bis(4-aminocyclohexyl)propane, methylcyclohexanediamine, norbornanediamine, tricyclodecanediamine, polyetheramine JEFFAMINE ED900, meta- or para-xylylenediamine, and meta- or para-phenylenediamine. Preferred are isophoronediamine and 1,3-bis(aminomethyl)cyclohexane.

On the other hand, examples of the tertiary nitrogen atom-containing diamine include a diamine containing a basic tertiary nitrogen atom in a main chain or side chain thereof. Specific examples thereof include piperazine ring-containing diamines and diamines other than the piperazine ring-containing diamines. Specific examples of the piperazine ring-containing diamines include piperazine ring-containing diamines such as N,N'-bis(aminomethyl)piperazine, N,N'-bis(2-aminoethyl)piperazine, N,N'-bis(2-aminoethyl)methylpiperazine, N-(aminomethyl)-N'-(2-aminoethyl)piperazine, N,N'-bis(3-aminopentyl)piperazine, N-(2-aminoethyl)piperazine, N-(aminopropyl)piperazine, N-(ω-aminohexyl)piperazine, N-(3-aminocyclohexyl)piperazine, N-(2-aminoethyl)-3-methylpiperazine, N-(2-aminoethyl)-2,5-dimethylpiperazine, N-(2-aminopropyl)-3-methylpiperazine, and N-(3-aminopropyl)-2,5-dimethylpiperazine.

Examples of the diamines other than the piperazine ring-containing diamines include N,N-di(2-aminoethyl)amine, N,N-di(3-aminopropyl)amine, N,N-di(2-aminoethyl)methylamine, N,N-di(3-aminopropyl)ethylamine, N,N-di(3-aminopropyl)isopropylamine, N,N-di(3-aminopropyl)cyclohexylamine, N,N-di(4-amino-n-butyl)amine, N-methyl-N-(2-aminoethyl)-1,3-propanediamine, N,N'-dimethyl-N,N'-di(3-aminopropyl)ethylenediamine, N,N'-dimethyl-N,N'-di(3-aminopropyl)tetramethylenediamine, N,N'-diisobutyl-N,N'-di-(3-aminopropyl)hexamethylenediamine, N,N'-dicyclohexyl-N,N'-di-(3-aminopropyl)hexamethylenediamine, N,N'-dicyclohexyl-N,N'-bis(2-carboxypropyl)hexamethylenediamine, N,N'-di-(3-aminopropyl)-2,2,4-trimethyl-hexamethylenediamine, 1,2-bis(3-aminopropoxy)-2-methyl-2-(N,N-dimethylaminomethyl)propane, 1,2-bis(3-aminopropxy)-2-methyl-2-(N,N-diethylaminomethyl)propane, 1,2-bis(3-aminopropoxy)-2-ethyl-2-(N,N-dimethylaminomethyl)propane, and 1,3-bis(3-aminopropoxy)-2-(N,N-dimethylaminomethyl)propane. Preferred are N,N'-bis(3-aminopropyl)piperazine and N-(2-aminoethyl)piperazine.

Examples of the dicarboxylic acid include an aromatic dicarboxylic acid, an aliphatic dicarboxylic acid, an unsaturated alicyclic dicarboxylic acid, and an alicyclic dicarboxylic acid. These dicarboxylic acids can be used singly or in combination of two or more thereof.

Examples of the aromatic dicarboxylic acid include terephthalic acid, isophthalic acid, orthophthalic acid, 2,6-naphthalenedicarboxylic acid, 1,5-naphthalenedicarboxylic acid, 5-sodiumsulfoisophthalic acid, 5-lithiumsulfoisophthalic acid, 5-sodiumsulfoterephthalic acid, 4,4'-diphenylmethanedicarboxylic acid, 4,4'-diphenyletherdicarboxylic acid, 4,4'-biphenyldicarboxylic acid, 4,4'-stilbenedicarboxylic acid, p-oxybenzoic acid, p-(hydroxyethoxy)benzoic acid, and β-hydroxynaphthoic acid. Examples of the aliphatic dicarboxylic acid include adipic acid, glutaric acid, decanedicarboxylic acid, pimeric acid, suberic acid, azelaic acid, sebacic acid, dodecanedioic acid, and dimer acid. Examples of the unsaturated alicyclic dicarboxylic acid include fumaric acid, maleic acid, itaconic acid, hexahydrophthalic acid, and tetrahydrophthalic acid. Examples of the alicyclic dicarboxylic acid include isophoronedicarboxylic acid, 1,4-cyclohexanedicarboxylic acid, 2,3-norbornanedicarboxylic acid, 1,3-cyclohexanedicarboxylic acid, 2-methyl-1,4-cyclohexanedicarboxylic acid, 2-ethyl-1,4-cyclohexanedicarboxylic acid, 2-propyl-1,4-cyclohexanedicarboxylic acid, 2-butyl-1,4-cyclohexanedicarboxylic acid, 2-t-butyl-1,4-cyclohexanedicarboxylic acid, 2,3-dimethyl-1,4-cyclohexanedicarboxylic acid, 2,3-diethyl-1,4-cyclohexanedicarboxylic acid, 2,3-dipropyl-1,4-cyclohexanedicarboxylic acid, 2,3-dibutyl-1,4-cyclohexanedicarboxylic acid, 2-methyl-3-ethyl-1,4-cyclohexanedicarboxylic acid, 2-methyl-3-propyl-1,4-cyclohexanedicarboxylic acid, 2-methyl-3-butyl-1,4-cyclohexanedicarboxylic acid, 2-ethyl-3-propyl-1,4-cyclohexanedicarboxylic acid, 2-ethyl-3-butyl-1,4-cyclohexanedicarboxylic acid, 2-methyl-3-t-butyl-1,4-cyclohexanedicarboxylic acid, 1,2-cyclohexanedicarboxylic acid, 2,6-decalindicarboxylic acid, 3-methyl-2,6-decalindicarboxylic acid, 3-ethyl-2,6-decalindicarboxylic acid, 3-propyl-2,6-decalindicarboxylic acid, 3-butyl-2,6-decalindicarboxylic acid, 3,4-dimethyl-2,6-decalindicarboxylic acid, 3,4-diethyl-2,6-decalindicarboxylic acid, 3,4-dipropyl-2,6-decalindicarboxylic acid, 3,4-dibutyl-2,6-decalindicarboxylic acid, 3,8-dimethyl-2,6-decalindicarboxylic acid, 3,8-diethyl-2,6-decalindicarboxylic acid, 3,8-dipropyl-2,6-decalindicarboxylic acid, 3,8-dibutyl-2,6-decalindicarboxylic acid, 3-methyl-4-ethyl-2,6-decalindicarboxylic acid, 3-methyl-4-propyl-2,6-decalindicarboxylic acid, 3-methyl-4-butyl-2,6-decalindicarboxylic acid, and 3-ethyl-4-butyl-2,6-decalindicarboxylic acid. Among these dicarboxylic acids, adipic acid and 1,4-cyclohexanedicarboxylic acid are preferred in terms of gradation print reproducibility of a highlight part.

As to the polyamide of the present invention, for example, a known aminocarboxylic acid or lactam, a derivative thereof, or the like can be used as far as it does not affect the characteristics of the polyamide. Examples of the aminocarboxylic acid include 4-aminocyclohexanecarboxylic acid, 3-aminocyclohexanecarboxylic acid, 4-(aminomethyl)cyclohexanecarboxylic acid, 3-(aminomethyl)cyclohexanecarboxylic acid, and 2-aminomethylcyclopropanecarboxylic acid. Examples of the lactam include ε-caprolactam and ω-laurolactam. These polyamides can be used singly or in combination of two or more thereof.

As to a method of setting the glass transition temperature of the polyamide used as the water-soluble or water-dispersible resin (B) to a specific range, there is, for example, introduction of a ring structure such as an aromatic ring or an aliphatic ring into a molecular chain. As to a specific method of increasing or decreasing the glass transition temperature, there is, for example, increasing or decreasing the content rate (mol%) of an alicyclic structural unit obtained from the diamine and the dicarboxylic acid in the polyamide.

The polymerization for the polyamide of the present invention can be performed, for example, by a known method.

The mole ratio (amino group/carboxyl group) between the diamine and the dicarboxylic acid to be polymerized for the polyamide of the present invention is, for example, 1.0 or more and preferably 1.01 or more. By setting the mole ratio to the range described above, a polymer can be extracted after polymerization equilibrium is achieved, and the variation of molecular weight can be suppressed.

The polyether urethane urea of the present invention can be obtained, for example, by addition polymerization of a diamine with a polyethylene glycol-containing diisocyanate-terminated compound. The obtained polyether urethane urea can further be reacted with a diisocyanate compound so as to give a polymer having an increased molecular weight.

As to the diamine, the same raw materials as for the polyamide can be used. A piperazine ring-containing diamine, such as N,N'-bis(aminoethyl)-piperazine, N,N'-bis(3-aminopropyl)piperazine, and N-(2-aminoethyl)piperazine, is preferred from the viewpoint of polymerizability.

The other raw material, i.e., the polyethylene glycol-containing diisocyanate-terminated compound, for synthesizing the polyether urethane urea is a diisocyanate compound having isocyanate groups substantially at both terminals, obtained by reacting a known aliphatic, alicyclic, or aromatic diisocyanate with equimolar or less polyoxyethylene glycol.

As to the diisocyanate used to obtain the polyethylene glycol-containing diisocyanate-terminated compound, a known aliphatic, alicyclic, or aromatic diisocyanate can be used. Examples thereof include 2,4-tolylene diisocyanate, 2,6-tolylene diisocyanate, 4,4'-diphenylmethane diisocyanate, 4,4'-dicyclohexylmethane diisocyanate, p-xylylene diisocyanate, 1,3-cyclohexanedimethyl diisocyanate, p-xylylene diisocyanate, 1,5-naphthalene diisocyanate, 2,6-diisocyanatemethyl caproate, diphenylether-4,4'-diisocyanate, hexamethylene diisocyanate, and isophorone diisocyanate. The diisocyanate is preferred to be an aliphatic diisocyanate, particularly preferred to be hexamethylene diisocyanate in terms of storage stability and reactivity.

The polymerization for the polyether urethane urea of the present invention can be performed, for example, by a known method. Examples thereof include a method of reacting both the materials under mixing and stirring, using no solvent, and a method of reacting both the materials dissolved in an inactive solvent.

The mole reaction ratio (amino group/isocyanate group) between the diamine and the diisocyanate compound to be polymerized for the polyether urethane urea is 1.0 or more and preferably 1.02 or more. In this case, excessive terminal amino groups are allowed to remain unreacted as long as the performance, the physical properties, and the like of a composition containing the unreacted terminal amino groups are adversely affected. When the equivalent ratio amino group/isocyanate group is less than 1.0, an inconvenient reaction such as gelation is easily caused, and such an equivalent ratio is not preferred. The reactivity between an amine and an isocyanate is very large. Therefore, both the materials can be reacted even in an active solvent such as water, an alcohol (e.g., methanol), and a mixture of water and an alcohol, and further, the reaction is rapidly completed. Both the materials should be reacted under conditions optimal to the system thereof, but are rapidly reacted even in a relatively low temperature, for example, a room temperature.

As to a method of setting the glass transition temperature of the polyether urethane urea used as the water-soluble or water-dispersible resin (B) to a specific range, there is, for example, adjustment of the amount of urea bonds and the amount of an alkylene glycol component in the resin. As to a specific method of increasing or decreasing the glass transition temperature, there is, for example, increasing or decreasing the content rate (mol%) of urea bonds and an alkylene glycol component obtained from the polyethylene glycol-containing diisocyanate-terminated compound and the dicarboxylic acid in the polyether urethane urea.

The polyamide or the polyether urethane urea used as the resin (B) is water-soluble or water-dispersible (water-developable). In order to satisfy this condition, a polar group-containing diamine or dicarboxylic acid may be selected. The diamine may be selected from an aliphatic diamine, an aromatic diamine, a heterocyclic diamine, or an alicyclic diamine. Among these diamines, tertiary nitrogen atom-containing diamines such as a piperazine ring-containing diamine and methyliminobispropylamine are preferred in terms of water developability. Further, a piperazine ring-containing diamine is particularly preferably used from the viewpoint of elastic modulus of the polymer. Examples of the piperazine ring-containing diamine include 1,4-bis(3-aminoethyl)piperazine, 1,4-bis(3-aminopropyl)piperazine, and N-(2-aminoethyl)piperazine.

The water-soluble or water-dispersible resin (A) used in the upper layer is preferred to be a resin having a glass transition temperature (Tg) measured by differential scanning calorimeter of 40°C or higher and 90°C or lower. The glass transition temperature is more preferred to be 55°C or higher and 85°C or lower, and further preferred to be 65°C or higher and 80°C or lower. The water-soluble or water-dispersible resin (A) having an excessively low glass transition temperature sometimes degrades the plate-surface adhesiveness, and the water-soluble or water-dispersible resin (A) having an excessively high glass transition temperature may possibly decrease the plate life.

The resin used as the resin (A) is preferred to be a resin selected from a polyamide, a polyether urethane urea, or a polyether amide.

The polyamide used as the resin (A) is formed of a combination of a diamine and a dicarboxylic acid, and an aminocarboxylic acid may be combined as necessary. As to these raw materials, the same raw materials as for the polyamide of the resin (B) can be used, but by appropriately setting the content rate of the ring-structure diamine or the dicarboxylic acid, the glass transition temperature (Tg) can be set to 40°C or higher and 90°C or lower.

The polyether urethane urea used as the resin (A) is formed of a combination of a diamine and a diisocyanate compound. As to these raw materials, the same raw materials as for the polyether urethane urea of the resin (B) can be used, but by appropriately setting the content rate of the ring-structure diamine, the glass transition temperature (Tg) can be set to 40°C or higher and 90°C or lower.

The polyether amide used in the present invention is, for example, a polyamide having a polyether bond and an amide bond in a main chain thereof, and contains polyethylene glycol as a polyether component. The polyether amide can be synthesized by polymerization according to, for example, a method described in Japanese Patent Application Laid-Open (JP-A) No. 74537/80.

Specifically, the polyether amide can be synthesized by a known polymerization method using a constituent unit formed of polyethylene glycol having an amino group at a terminal and an aliphatic dicarboxylic acid, and a constituent unit of other polyamide. The polyether amide may be a polyether ester amide containing an ester bond in a molecule thereof. Introduction of a tertiary nitrogen atom can be achieved by copolymerizing a constituent unit that includes a tertiary nitrogen atom-containing diamine or dicarboxylic acid as a polyamide component used as a hard segment. The introduction of a tertiary nitrogen atom can facilitate the design of water solubility or water dispersibility for the resin.

The polyamide used in the polymerization for the polyether amide is a homopolymer or a copolymer, or a mixture of two or more thereof, the homopolymer and the copolymer being synthesized, according to a known method, from a diamine and dicarboxylic acid, ω-amino acid or a lactam, a derivative thereof, or the like. Examples of the polyamide include various types of nylon such as nylon 6, nylon 66, nylon 610, nylon 6/66/610, and nylon 6/66/612, a polyamide obtained from meta-xylenediamine and adipic acid, a diaminodicyclohexylmethane copolyamide, a basic nitrogen-containing copolyamide containing, for example, a constituent unit of N,N'bis(3-aminopropyl)piperazine and adipic acid, polyether-containing polyamides such as a polyethylene glycol copolyamide containing amino groups at both terminals, and a polyethylene glycol copolyamide containing carboxyl groups at both terminals, and N-methylolated products and N-alkoxymethylated products of various polyamides. Among these polyamides, a basic nitrogen-containing copolyamide and a polyether-containing polyamide are preferred.

As to a method of introducing basic nitrogen into the polyamide, use of a diamine containing a basic tertiary nitrogen atom in a main chain or side chain thereof is preferred. Specific examples of the diamine include piperazine ring-containing diamines such as N,N'-bis(aminomethyl)piperazine, N,N'-bis(2-aminoethyl)piperazine, and N,N'-bis(3-aminopropyl)piperazine. N,N'-bis(3-aminopropyl)piperazine is particularly preferred.

Examples of the polyether include a polyoxyalkylene glycol having a number average molecular weight of 200 to 4,000. Specific examples of the polyoxyalkylene glycol include polyoxyethylene glycol having a number average molecular weight of 200 to 4,000, polyoxypropylene glycol having a number average molecular weight of 200 to 4,000, and polytetramethylene glycol having a number average molecular weight of 200 to 4,000. As to the polyether, polyoxyethylene glycol having a molecular weight of 400 to 1,500 is preferred in terms of achieving both rebound resilience and flexibility.

The glass transition temperature (Tg) of the polyether amide can be set to 40°C or higher and 90°C or lower by appropriately setting the content rate of the polyether component derived from polyethylene glycol.

It is possible to determine whether or not the resin (A) and the resin (B) are water-soluble or water-dispersible by singly immersing the polyamide, the polyether amide, or the polyether urethane urea in 30°C water or acidic water and rubbing it with a brush or the like. When the photosensitive resin is uniformly mixed in the water or acidic water after the physical rubbing with a brush or the like, this resin is determined to be water-soluble. On the other hand, part or the whole surface of the photosensitive resin is swollen, and dispersed and ununiformly mixed in the water after the physical rubbing with a brush or the like, this resin is determined to be water-dispersible.

The photosensitive resin compositions used for the upper layer and the lower layer are formed of the resin (A), the resin (B), and a photopolymerizable unsaturated compound and a photopolymerization initiator, and any additive such as a plasticizer, a thermal polymerization inhibitor, a dye, a pigment, an ultraviolet absorber, a perfume, and an antioxidant. The photosensitive resin compositions used for the upper layer and the lower layer are preferred to contain the same compounds in terms of storage stability. Particularly, the resin (A) and the resin (B) are preferred to be the same resin in terms of interlayer adherence.

In the photosensitive resin compositions for the photosensitive resin layers of the present invention, when the water-soluble or water-dispersible resin contains basic tertiary nitrogen atoms, at least part of the atoms is preferred to be quaternized by a quaternizing agent. The quaternizing agent may be a protic quaternizing agent or a non-protic quaternizing agent. Specific examples thereof include maleic acid, itaconic acid, acrylic acid, methacrylic acid, cinamic acid, glycolic acid, lactic acid, succinic acid, adipic acid, benzoic acid, glycidyl methacrylate, and glycidyl acrylate. Glycidyl methacrylate and glycidyl acrylate are particularly preferred. The quaternizing agent can be contained maximally at an amount of 0.70 mol and particularly maximally at an amount of 0.60 mol in 1000 g of the polymer compound.

As to a method of preparing the polymer compound containing a desired amount of basic tertiary nitrogen atoms quaternized by a photopolymerizable group-containing non-protic quaternizing agent, for example, it is possible to set the desired amount by determining the amount of basic tertiary nitrogen atoms by the blending ratio of a basic tertiary nitrogen atom-containing raw material in the water-soluble or water-dispersible resin, and further increasing or decreasing the quaternization rate achieved by the photopolymerizable group-containing quaternizing agent with respect to the amount of the introduced basic tertiary nitrogen atoms. The quaternization rate is a ratio in number of moles of the quaternized basic tertiary nitrogen atoms to the basic tertiary nitrogen atoms contained in the polymer compound, and is represented by mol%. The quaternization rate achieved by the quaternizing agent is preferably 0 to 50% and further preferably 20 to 50%. It is also possible to perform the quaternization only by a thermal acid generator, without using the quaternizing agent, but the combination use of the quaternizing agent improves resinous residue-removing stability. By setting the quaternization rate achieved by the quaternizing agent to 50% or less, it is possible to suppress damage to an image part during water washing.

The usage of the water-soluble or water-dispersible resin used in the present invention is preferably 45 to 65% by weight in the whole photosensitive resin composition. When the usage is less than 45% by weight, sufficient physical properties may not be obtained. When the usage is more than 65% by weight, photocurability may be degraded, sometimes decreasing image reproducibility. In order to satisfy both the physical properties and the image reproducibility, the usage is further preferably 50 to 65% by weight.

The photopolymerizable unsaturated compound used in the present invention is, for example, a compound containing one or more photopolymerizable unsaturated groups in a molecule thereof, and a known compound can be used. Examples of a compound containing one photopolymerizable unsaturated group in a molecule thereof include compounds having one unsaturated bond, such as 2-hydroxyethyl (meth)acrylate, 2-hydroxypropyl (meth)acrylate, 3-chloro-2-hydroxypropyl (meth)acrylate, cyclohexyl (meth)acrylate, benzyl (meth)acrylate, N,N'-dimethylaminoethyl (meth)acrylate, glycidyl (meth)acrylate, (meth)acrylamide, N-methylol(meth)acrylamide, N-methylol(meth)acrylamide-n-butyl ether, diacetoacrylamide, N-tert-butyl(meth)acrylamide, a ring-opening addition reaction product of glycidyl (meth)acrylate and a monoalcohol, and 2-acrylamide-2-methylpropanesulfonic acid. Examples of a compound containing two or more photopolymerizable unsaturated groups in a molecule thereof include compounds having two or more unsaturated bonds, such as ethylene glycol di(meth)acrylate, 1,3-propanediol di(meth)acrylate, 1,4-butanediol di(meth)acrylate, 1,6-hexandiol di(meth)acrylate, glycerin dimethacrylate, 2-hydroxy-3-acryloyloxypropyl methacrylate, trimethylolethane di(meth)acrylate, trimethylolethane tri(meth)acrylate, trimethylolpropane di(meth)acrylate, trimethylolpropane tri(meth)acrylate, tetramethylolmethane di(meth)acrylate, tetramethylolmethane tri(meth)acrylate, tetramethylolmethane tetra(meth)acrylate, tri(meth)acryloyloxyethyl phosphate, a triester of tris(2-hydroxyethyl)isocyanuric acid and (meth)acrylic acid, a ring-opening addition reaction product of a polyglycidyl ether of a polyhydric alcohol with (meth)acrylic acid (e.g., a reaction product of (poly)ethylene glycol diglycidyl ether with (meth)acrylic acid, a reaction product of a diglycidyl ether of (poly)propylene glycol with (meth)acrylic acid, a reaction product of a diglycidyl ether of 1,6-hexamethylene glycol with (meth)acrylic acid, a reaction product of glycerin diglycidyl ether with (meth)acrylic acid, a reaction product of trimethylolethane triglycidyl ether with (meth)acrylic acid, a reaction product of trimethylolpropane triglycidyl ether with (meth)acrylic acid, a reaction product of isophthalic acid diglycidyl ether with (meth)acrylic acid, and a reaction product of a diglycidyl ether of a dicarboxylic acid of an isoprene oligomer with (meth)acrylic acid), a ring-opening addition reaction product of other active hydrogen compound with glycidyl (meth)acrylate (e.g., a reaction product of (poly)ethylene glycol with glycidyl (meth)acrylate, a reaction product of (poly)propylene glycol with glycidyl (meth)acrylate, a reaction product of glycerin with glycidyl (meth)acrylate, a reaction product of 2-hydroxyethyl (meth)acrylate with glycidyl (meth)acrylate, a reaction product of trimethylolethane with glycidyl (meth)acrylate, a reaction product of trimethylolpropane with glycidyl (meth)acrylate, a reaction product of (meth)acrylic acid with glycidyl (meth)acrylate, a reaction product of an aliphatic polyvalent carboxylic acid with glycidyl (meth)acrylate, and a reaction product of an aromatic polyvalent carboxylic acid with glycidyl (meth)acrylate), a compound having two or more unsaturated groups, obtained by a reaction of a primary or secondary amino group-containing compound with glycidyl (meth)acrylate, N,N'-methylenebis(meth)acrylamide, N,N'-ethylenebis(meth)acrylamide, N,N'-propylenebis(meth)acrylamide, N,N'-hexamethylenebis(meth)acrylamide, N,N'-m-phenylenebis(meth)acrylamide, N,N'-m-xylylenebis(meth)acrylamide, di(meth)acrylamide-N-methyl ether, 1,3-bis[(meth)acryloylaminomethyl]urea and a derivative thereof, 1,3-[bis(meth)acryloylaminomethyl]-1,3-dimethylurea and a derivative thereof, 1,3-[bis(meth)acryloylaminomethyl]ethyleneurea and a derivative thereof, 1,3-[bis(meth)acryloylaminomethyl]trimethyleneurea and a derivative thereof, triacrylformal, a tri(meth)acrylate of tris(2-hydroxyethyl)isocyanuric acid, and 1,3-diglycidyl,5-methyl,5-ethylhydantoin. Among these photopolymerizable unsaturated compounds, preferred are glycerin dimethacrylate, 2-hydroxy-3-acryloyloxypropyl methacrylate, a reaction product of trimethylolpropane with glycidyl (meth)acrylate, and a reaction product of glycerin with glycidyl (meth)acrylate.

The photopolymerizable unsaturated compounds may be used singly or in combination of two or more thereof. The usage of the photopolymerizable unsaturated compound is preferably 25 to 50% by weight in the whole photosensitive resin composition. When the usage of the photopolymerizable unsaturated compound is more than 50% by weight, sufficient mechanical strength may not be obtained. When the usage is less than 25% by weight, photocurability may be degraded, sometimes decreasing image reproducibility.

As to the photopolymerization initiator, a known photopolymerization initiator can be used. Specific examples thereof include benzophenones, benzoins, acetophenones, benzyls, benzoin alkyl ethers, benzyl alkyl ketals, anthraquinones, and thioxanthones. Suitable specific examples thereof include benzophenone, benzoin, acetophenone, benzoin methyl ether, benzoin ethyl ether, benzyl dimethyl ketal, anthraquinone, 2-chloroanthraquinone, thioxanthone, and 2-chlorothioxanthone. Among these photopolymerization initiators, benzyl dimethyl ketal is preferred, and may be combined with a benzophenone or an acetophenone. The usage of the photopolymerization initiator is preferably 0.05 to 5% by weight in the whole photosensitive resin composition. When the usage is less than 0.05% by weight, a photopolymerization initiating capability may be disrupted. When the usage is more than 5% by weight, photocurability in the thickness direction of the photosensitive resin layer of the printing plate precursor may be decreased in the making of a relief for printing and a missing image may be easily generated.

Further, a known thermal polymerization inhibitor may be added as necessary. The thermal polymerization inhibitor is added to prevent unexpected thermal polymerization caused by heating in the preparation, production, or molding process of the photosensitive resin composition, or prevent a dark reaction during storage of the composition. Examples of the thermal polymerization inhibitor include hydroquinones such as hydroquinone, mono-tert-butylhydroquinone, 2,5-di-tert-butylhydroquinone, and hydroquinone monomethyl ether, benzoquinones such as benzoquinone and 2,5-diphenyl-p-benzoquinone, phenols, catechols such as catechol and p-tert-butylcatechol, aromatic amine compounds, picric acids, phenothiazine, α-naphthoquinones, anthraquinones, nitro compounds, and sulfuric compounds. The usage of the thermal polymerization inhibitor is preferably 0.001 to 2% by weight and particularly preferably 0.005 to 1% by weight in the whole photosensitive resin composition. These compounds may be used in combination of two or more thereof.

A known plasticizer may be blended in the photosensitive resin composition of the present invention. The plasticizer is preferred to be a hydrophilic plasticizer, and examples thereof include ethylene oxide addition products and propylene oxide addition products of polyhydric alcohols such as ethylene glycol, diethylene glycol, triethylene glycol, tetraethylene glycol, glycerin, and glycerin.

The photosensitive resin composition of the present invention can be molded into an objective laminate structure by a melt molding method, or, for example, heat pressing or cast molding, or by any known method such as melt extrusion and solution cast so as to give a plate precursor for relief printing comprising a photosensitive resin layer.

The plate precursor for relief printing can be used after formation thereof by stacking a sheet-shaped molded article (unexposed resin) on a support with or without a known adhesive interposed between the molded article and the support. As to the support, any material, for example, steel, aluminum, glass, or a plastic film such as a polyester film can be used, and a film having a thickness in a range of 50 to 500 um is used. When the plate precursor for relief printing is supplied as a laminate obtained by stacking a sheet-shaped molded article (unexposed resin) on a support, it is preferred to further stack a protective film in contact with the sheet-shaped molded article (unexposed resin). As to the protective film, a film-shaped plastic film can be used, and, for example, a polyester film having a thickness of 125 um is used. Further, between the photosensitive resin layer and the protective film, an adhesion prevention layer may be disposed, the adhesion prevention layer being formed by applying a polymer, which is non-adhesive, transparent, and dispersible or soluble in a developer, at a thickness of 0.5 to 3 um. By disposing the adhesion prevention layer on a surface of the photosensitive resin layer, even when the photosensitive resin layer has a high surface adhesiveness, the peeling of the protective film performed in the following exposure operation can easily be performed.

As to a method of obtaining the photosensitive resin layer of the present invention that has a structure comprising the lower layer present on the support side and the upper layer present on the cover-film side, a known production method can be used, and desired in terms of productivity is a method of laminating the uppermost layer, i.e., the cover film having the photosensitive resin composition stacked thereon, and the lower layer.

By disposing a thermosensitive mask layer on a surface of the photosensitive resin layer, the plate precursor for relief printing of the present invention can be produced into a CTP (Computer To Plate) plate that needs no use of a negative film. As to the thermosensitive mask layer, a known thermosensitive mask layer can be used.

For example, by layering a negative film having a transparent image part closely on the photosensitive resin layer, and applying an active light beam from thereabove to perform exposure, a plate precursor is obtained wherein only an exposed portion to which the active light beam has passed is made insoluble. Used for the active light beam is a light source normally having a main wavelength of 300 to 450 nm, such as a high-pressure mercury lamp, a super high-pressure mercury lamp, a metal halide lamp, a xenon lamp, and a chemical lamp. On the other hand, in the cases of the CTP plate, IR laser is, in an image pattern, applied to the thermosensitive mask layer to form a mask (the same function as the negative film) on the photosensitive resin layer. After writing image information on the thermosensitive mask layer, an active light beam is applied onto the whole surface of the photosensitive printing plate precursor via the mask so as to make a plate precursor wherein only an exposed portion to which the active light beam has passed is made insoluble.

Next, an unexposed portion (uncured portion) is dissolved and removed by an appropriate solvent, particularly neutral water. The unexposed portion can be dissolved and removed by a developing system such as a spray developing device and a brush developing device. Thereafter, the printing plate having the unexposed portion dissolved and removed therefrom is subjected to draining off of water, drying, and a post exposure step so as to give a final printing plate.

It has been found that when the plate precursor for relief printing obtained from the photosensitive resin composition of the present invention is used, both gradation printability of a highlight part and plate life are excellent and further the plate-surface adhesiveness is very low. Therefore, by using the plate precursor for relief printing according to the present invention, high-quality printing of a large amount of copies can be performed with one plate. Further, due to the decrease of plate-surface adhesiveness, adhesion of dust or paper powder is decreased before and during printing, and the number of times of washing the plate for removing the adhered matter can greatly be reduced.

### Examples

Hereinafter, the present invention is further described in detail by way of examples. The present invention, however, is not limited to these examples. In the examples (description), parts represent parts by mass. The polyamide composition in Table 1 is represented by mol%. The mol% of the polyamide composition was determined by H-NMR measurement. The evaluation of characteristic values in the examples was performed according to the following methods.

### (1) Printability of highlight part (gradation print reproducibility of highlight part)

First, using a printing evaluation negative, a plate precursor for relief printing that comprises a photosensitive resin layer having a thickness of 685 um was exposed to light, with a chemical lamp having the illuminance thereof adjusted to 25 W/m². The light was applied at a height distance of 5 cm from a surface of the photosensitive resin. The printing evaluation negative comprises an image with 1% to 95% halftone dots formed at 200 lpi of screen-ruling, wherein minimum independent dots have a diameter of 50 to 600 um, and wherein minimum independent lines has a width of 10 to 150 um. The printing evaluation negative further comprises a solid image (width 1 cm × length 5 cm). As to an exposing time, a minimum exposing time necessary for reproducing 1% halftone dots at 200 lpi of screen-ruling was adopted as an optimal exposing time. Next, development was performed using a brush washer (120 µmϕ nylon brush, JW-A2-PD type produced by Nihon Denshi Seiki Co., Ltd.) with 25°C tap water so as to give a relief image. Further, hot-air drying was performed at 60°C for 10 min, then post exposure was performed for 30 seconds with a super high-pressure mercury lamp, and a printing plate was thus obtained. The image reproducibility of 1% halftone dots at 200 lpi of screen-ruling was determined by the naked eye using a 10-power loupe. The obtained printing plate was evaluated for highlight printability. As to a printer, rotary printing machine P-20 (manufactured by SANJO MACHINE WORKS, LTD.) was used, as to an ink, BESTCURE indigo (manufactured by T & K TOKA CO., LTD.) was used, and as to a printing material, gloss PW-8K (manufactured by LINTEC Corporation) was used. The printing pressure (pressure between the plate and the printing material) was gradually increased and a pressure at which the solid part exhibited no blur was adopted as an appropriate pressure. Then, the printing evaluation was performed. The ink feed amount was adjusted such that the ink density of the solid part was 1.7 abs. The halftone dot density of a part printed with 1% to 5% halftone dots formed at 200 lpi of screen-ruling and at the appropriate pressure was measured using CCDOT4 (manufactured by SDG). The results were represented by % and shown in Table 1. The printability of a highlight part is evaluated as excellent when the halftone dot density of the printed material is close to the halftone dot density of the negative film and the halftone dot density of the printed material smoothly decreases according as the halftone dots of the negative film decrease from 5% to 1%.

### (2) Plate-surface adhesiveness

A printing plate was produced by the same method as when the relief for evaluating the printability of a highlight part in (1) was made. The obtained printing plate was evaluated for adhesiveness of a surface of the printing plate. The adhesiveness was evaluated according to the following criteria based on the degree of slippage of a printing material, i.e., coated paper (gloss PW-8K manufactured by LINTEC Corporation), pressed against the plate.
o: The coated paper slips freely.
Δ: The coated paper adheres to the plate but slips when having force applied thereto.
x: The coated paper adheres to the plate and does not slip.

### (3) Plate life (crack of solid-image part)

A printing plate was produced by the same method as when the relief for evaluating the printability of a highlight part in (1) was made. Printing of 20000 shots was performed at a high printing pressure which is higher than the appropriate printing pressure by 100 um. A printed material and the plate were observed with a microscope at a magnification of 200 times after printing of 10000 shots and printing of 20000 shots, respectively, and evaluated according to the following criteria.
oo: The printed material has no defect, and the plate has no crack.
o: The printed material has no defect, but the plate has a slight crack.
Δ: The printed material has no defect confirmed by visual inspection, but has a failure observed with a microscope at a magnification of 200 times.
×: The printed material has a failure confirmed by visual inspection.

### (4) Glass transition temperature (Tg)

The glass transition temperature was measured using differential scanning calorimeter DSC100 manufactured by TA Instruments, Inc. A polyamide resin (10.0 mg) was put in an aluminum pan, and heated at a temperature rise rate of 10°C/min to 230°C. The polyamide resin having reached 230°C was retained for 3 min and then immediately quenched in liquid nitrogen. Thereafter, the polyamide resin was heated at a temperature rise rate of 10°C/min from a room temperature to 300°C, and the glass transition temperature (Tg) was obtained. Tg was defined as the temperature at an intersection point between a base line and a tangent at an inflection point.

### Polymerization example of polyamide resin A-1

ε-Caprolactam (394.9 parts), adipic acid (469.1 parts), 1,4-bis(3-aminopropyl)piperazine (340.5 parts), 1,3-bis(aminomethyl)cyclohexane (199.1 parts), isophoronediamine (34.1 parts), a 50% aqueous solution of hypophosphorous acid (5 parts), and water (1000 parts) were charged into an autoclave. After nitrogen substitution, the autoclave was hermetically sealed and gradually heated. Water was distilled out from the time point at which the inner pressure reached 0.4 MPa until the inner pressure was no longer maintained. The inner pressure was returned to an ordinary pressure in about 2 hours. Thereafter, a reaction was performed at an ordinary pressure for 1 hour. The highest polymerization reaction temperature was 255°C. Thereby, a polyamide having a glass transition temperature of 35°C was obtained. The composition of the polyamide was measured by H-NMR, and no difference was confirmed between the charging composition and the polymer composition.

### Polymerization of polyamide resins A-2 to A-4, A-7, B-1 to B-5, and B-8

Polyamide resins A-2 to A-4, A-7, B-1 to B-5, and B-8 were obtained by polymerization according to the same method as for the polyamide resin A-1. However, the types and the blending ratio of the raw materials were changed as shown in Table 1. Table 1 shows the glass transition temperatures of the obtained resins.

### Polymerization of polyether amide resin B-6

Two equivalents (672.8 parts) of hexamethylene diisocyanate were put in a flask equipped with a dropping funnel, heated to 110°C in a nitrogen atmosphere, and then 1 equivalent (1200.0 parts) of polyethylene glycol having a number average molecular weight of 600 was, with the dropping funnel, dropped thereto under stirring. The stirring was continued for 30 min after the dropping. In the obtained compound, the amount of isocyanates was half the original amount. The hydroxy groups at both terminals of the polyethylene glycol were reacted with isocyanate groups, and thus, a PEG600-both terminal-HDI-modified product having isocyanate groups at both terminals was obtained.

Adipic acid (219.2 parts), 1,4-cyclohexanedicarboxylic acid (399.7 parts), 2-methylpentamethylenediamine (139.5 parts), 1,4-bis(3-aminopropyl)piperazine (320.5 parts), isophoronediamine (204.3 parts), a 50% aqueous solution of hypophosphorous acid (5 parts), and water (1000 parts) were charged into an autoclave. After nitrogen substitution, the autoclave was hermetically sealed and gradually heated. Water was distilled out from the time point at which the inner pressure reached 0.4 MPa until the inner pressure was no longer maintained. The inner pressure was returned to an ordinary pressure in about 2 hours. Thereafter, a reaction was performed at an ordinary pressure for 1 hour. The highest polymerization reaction temperature was 255°C. Thereby, a polyamide having a glass transition temperature of 135°C was obtained.

Next, the obtained polyamide (1288 parts) and α, ω-diaminopolyoxyethylene (120.0 parts) were dissolved in methanol (1690 parts), the α,ω-diaminopolyoxyethylene being obtained by addition of acrylonitrile to both terminals of polyoxyethylene glycol having an average molecular weight of 400 and hydrogen reduction of the addition product. Subsequently, the PEG600-HDI-modified product (655.9 parts) were gradually added under stirring of the mixture, which was reacted for about 45 min. This solution was put in a Teflon (registered trade name)-coated petri dish, had the methanol evaporated and removed therefrom, and then was dried under reduced pressure so as to give a polyether amide resin containing polyethylene glycol. The obtained resin had a glass transition temperature of 112°C.

### Polymerization example of polyether urethane urea resin A-5

Two equivalents (672.8 parts) of hexamethylene diisocyanate were put in a flask equipped with a dropping funnel, heated to 110°C in a nitrogen atmosphere, and then 1 equivalent (1200.0 parts) of polyethylene glycol having a number average molecular weight of 600 was, with the dropping funnel, dropped thereto under stirring. The stirring was continued for 30 min after the dropping. In the obtained compound, the amount of isocyanates was half the original amount. The hydroxy groups at both terminals of the polyethylene glycol were reacted with isocyanate groups, and thus, a PEG600-both terminal-HDI-modified product having isocyanate groups at both terminals was obtained.

Next, 1,4-bis(3-aminopropyl)piperazine (540.8 parts), N-(2-aminoethyl)piperazine (64.6 parts), isophoronediamine (323.5 parts) were dissolved in methanol (1115.0 parts), and then lactic acid (90.0 parts) was added and dissolved. Next, the PEG600-HDI-modified product (1030.7 parts) was gradually added to the diamine solution under stirring, and subsequently hexamethylene diisocyanate (HDI) (639.1 parts) was gradually added under stirring. Both reactions were completed in about 15 min. This solution was put in a Teflon (registered trade name)-coated petri dish, had the methanol evaporated and removed therefrom, and then was dried under reduced pressure so as to give a polymer compound. The obtained resin had a glass transition temperature of 55°C.

### Polymerization of polyether urethane urea resins A-6 and B-7

Polyether urethane urea resins A-6 and B-7 were obtained by polymerization according to the same method as for the polyether urethane urea resin A-5. However, the types and the blending ratio (mol%) of the raw materials were changed as shown in Table 1. Table 1 shows the glass transition temperatures of the obtained resins.

The raw materials used in the examples are as follows.
BAPP: N,N'-bis(3-aminopropyl)piperazine
AEP: N-(2aminoethyl)piperazine
IPDA: isophoronediamine
1,3-BAC: 1,3-bis(aminomethyl)cyclohexane
MPDA: 2-methylpentamethylenediamine
HMDA: 1,6-hexanediamine
CHDA: 1,4-cyclohexanedicarboxylic acid
HDI: 1,6-hexamethylene diisocyanate
IPDI: isophorone diisocyanate

Example 1

The polyamide resin (P1) (55.0 parts) was added to a mixture of methanol (62 parts) and water (10 parts) and heated at 65°C and dissolved, diethylene glycol (9.0 parts), lactic acid (5.0 parts) as a quaternizing agent, and hydroquinone monomethyl ether (0.1 part) were added and further dissolved under stirring for 30 min, and the polyamide was made into an ammonium salt and was thus made water-soluble. Thereafter, glycidyl methacrylate (GMA) (2.5 parts), benzyl dimethyl ketal (1.0 part) as a photopolymerization initiator, glycerin dimethacrylate (Light Ester G101P manufactured by kyoeisha Chemical Co., Ltd.) (13 parts), and 2-hydroxy-3-acryloyloxypropyl methacrylate (Light Ester G201P manufactured by kyoeisha Chemical Co., Ltd.) (14.5 parts) were added and dissolved under stirring for 30 min. Next, the mixture was gradually heated until the methanol and the water were distilled out, and the mixture was concentrated until the temperature in the kettle became 110°C. In this stage, a flowable and viscous photosensitive resin composition was obtained. This photosensitive resin composition was applied to a 100-um-thick polyethylene terephthalate film coated at a thickness of about 1.7 um with Poval having a saponification of 98%, and was dried at 100°C so as to give a cover film having the photosensitive resin composition stacked thereon at a thickness of 10 um.

In the meantime, the lower layer was prepared as follows. The polyamide resin (P6) (55.0 parts) was added to a mixture of methanol (62 parts) and water (10 parts) and heated at 65°C and dissolved, diethylene glycol (9.0 parts), lactic acid (5.0 parts) as a quaternizing agent, and hydroquinone monomethyl ether (0.1 part) were added and further dissolved under stirring for 30 min, and the polyamide was made into an ammonium salt and was thus made water-soluble. Thereafter, glycidyl methacrylate (GMA) (2.5 parts), benzyl dimethyl ketal (1.0 part) as a photopolymerization initiator, glycerin dimethacrylate (Light Ester G101P manufactured by kyoeisha Chemical Co., Ltd.) (13 parts), and 2-hydroxy-3-acryloyloxypropyl methacrylate (Light Ester G201P manufactured by kyoeisha Chemical Co., Ltd.) (14.5 parts) were added and dissolved under stirring for 30 min. Next, the mixture was gradually heated until the methanol and the water were distilled out, and the mixture was concentrated until the temperature in the kettle became 110°C. In this stage, a flowable and viscous photosensitive resin composition was obtained. The photosensitive resin composition was cast onto a 250-µm-thick polyethylene terephthalate film coated at a thickness of 20 um with an adhesive composition containing an ultraviolet absorber. Then, the photosensitive resin layer side of the cover film having the 10-pm-thick photosensitive resin composition stacked thereon was brought into contact with the photosensitive resin composition cast onto the 250-µm-thick polyethylene terephthalate film. Then, a raw plate of a sheet-shaped laminate having a total thickness of 1080 um was molded using a laminator.

After the raw plate was stored for 7 days or more, the printability of a highlight part, the plate-surface adhesiveness, and the plate life were evaluated. Tables 2 and 3 show these results.

### Examples 2 to 13 and Comparative Examples 1 to 6

Raw plates of sheet-shaped laminates having a total thickness of 1080 um were molded in the same manner as in Example 1. However, the resin (A) and the resin (B) of the photosensitive resin layers were changed as shown in Table 2. Table 2 shows these results.

**[Table 1]**

| | | | Resin A | | | | | | |
|---|---|---|---|---|---|---|---|---|---|
| | | | A-1 | A-2 | A-3 | A-4 | A-5 | A-6 | A-7 |
| Polymer composition (mol%) | diamine | BAPP | 17.0 | 100 | 18.0 | 13.0 | 27.0 | 45.0 | 20.0 |
| | | AEP | | 2.0 | | | 5.0 | 5.0 | |
| | | IPDA | 2.0 | | | 2.0 | 19.0 | | 2.0 |
| | | 1,3-BAC | 140 | 13.0 | | | | | |
| | | MPDA | | | 2.0 | 13.0 | | | 13.0 |
| | | methyliminobispropylamine | | 2.0 | 3.0 | 7.0 | | | |
| | | HMDA | | | 27.0 | | | | |
| | | α,ω-diaminopolyoxyethylene | | | | | | | |
| | carboxylic acid | adipic acid | 32.1 | 26.1 | 27.0 | | | | |
| | | CHDA | | | 23.0 | 34.6 | | | 34.6 |
| | ε-caprolactam | | 34.9 | 46.9 | | 30.4 | | | 30.4 |
| | diisocyanate | HDI | | | | | 38.0 | 8.0 | |
| | | IPDI | | | | | | 240 | |
| | alkylene glycol-containing compound | PEG600-both terminal-HDI-modified | | | | | 11.0 | | |
| | | PEG300-both terminal-HDI-modified | | | | | | 18.0 | |
| Glass transition temperature (°C) | | | 35 | 40 | 80 | 90 | 55 | 75 | 95 |

| | | | Resin B | | | | | | | |
|---|---|---|---|---|---|---|---|---|---|---|
| | | | B-1 | B-2 | B-3 | B-4 | B-5 | B-6 | B-7 | B-8 |
| Polymer composition (mol%) | diamine | BAPP | 150 | | 150 | | 20.0 | 16.0 | 6.0 | 30.0 |
| | | AEP | 8.0 | | 5.0 | 20.0 | | | 6.0 | 12.0 |
| | | IPDA | | | | 5.0 | 15.4 | 12.0 | | |
| | | 1,3-BAC | | 15.4 | 15.4 | 10.0 | | | | |
| | | MPDA | | | | | | | | |
| | | methyliminobispropylamine | | 20.0 | | | | | | |
| | | HMDA | 270 | | | | 150 | 12.0 | 38.0 | 80 |
| | | α,ω-diaminopolyoxyethylene | | | | | | 3.0 | | |
| | carboxylic acid | adipic acid | 27.0 | | | | 150 | 15.0 | | 8.0 |
| | | CHDA | 23.0 | 34.6 | 34.6 | 346 | 34.6 | 35.0 | | 42.0 |
| | ε-caprolactam | | | 30.0 | 30.0 | 30.4 | | | | |
| | diisocyanate | HDI | | | | | | | 22.0 | |
| | | IPDI | | | | | | | 26.0 | |
| | alkylene glycol-containing compound | PEG600-both terminal-HDI-modified | | | | | | 7.0 | 2.0 | |
| | | PEG300-both terminal-HDI-modified | | | | | | | | |
| Glass transition temperature (°C) | | | 90 | 95 | 113 | 126 | 135 | 112 | 120 | 156 |

**[Table 2]**

| | | | Example 1 | Example 2 | Example 3 | Example 4 | Example 5 | Example 6 | Example 7 |
|---|---|---|---|---|---|---|---|---|---|
| Upper layer | resin | | A-2 | A-3 | A-3 | A-4 | A-3 | A-5 | A-6 |
| | glass transition temperature (°C) | | 40 | 80 | 80 | 90 | 80 | 51 | 72 |
| | thickness (µm) | | 10 | 10 | 10 | 10 | 10 | 10 | 10 |
| Lower layer | resin | | B-2 | B-3 | B-4 | B-5 | B-6 | B-7 | B-7 |
| | glass transition temperature (°C) | | 95 | 113 | 126 | 135 | 112 | 117 | 117 |
| Evaluation results | printability of highlight part | 5% | 7 | 7 | 7 | 7 | 7 | 9 | 9 |
| | | 3% | 6 | 5 | 5 | 5 | 5 | 7 | 7 |
| | | 2% | 5 | 4 | 4 | 4 | 4 | 6 | 6 |
| | | 1% | 4 | 3 | 3 | 3 | 3 | 5 | 5 |
| | plate-surface adhesiveness | | Δ | ○ | ○ | ○ | ○ | Δ | ○ |
| | plate life | 10000 shots | ○○ | ○ | ○ | ○ | ○ | ○○ | ○ |
| | | 20000 shots | ○○ | ○ | ○ | Δ | ○ | ○○ | ○ |

| | | | Example 8 | Example 9 | Example 10 | Example 11 | Example 12 | Example 13 |
|---|---|---|---|---|---|---|---|---|
| Upper layer | resin | | A-2 | A-2 | A-4 | A-4 | A-3 | A-3 |
| | glass transition temperature (°C) | | 40 | 40 | 90 | 90 | 80 | 80 |
| | thickness (µm) | | 10 | 10 | 10 | 10 | 3 | 30 |
| Lower layer | resin | | B-2 | B-5 | B-2 | B-5 | B-3 | B-3 |
| | glass transition temperature (°C) | | 95 | 135 | 95 | 135 | 113 | 113 |
| Evaluation results | printability of highlight part | 5% | 7 | 7 | 7 | 7 | 7 | 7 |
| | | 3% | 6 | 5 | 6 | 5 | 5 | 5 |
| | | 2% | 5 | 4 | 5 | 4 | 4 | 4 |
| | | 1% | 4 | 3 | 4 | 3 | 3 | 3 |
| | plate-surface adhesiveness | | Δ | Δ | ○ | ○ | ○ | ○ |
| | plate life | 10000 shots | ○○ | ○○ | ○ | ○ | ○ | ○ |
| | | 20000 shots | ○○ | ○○ | Δ | Δ | Δ | ○ |

**[Table 3]**

| | | | Comparative Example 1 | Comparative Example 2 | Comparative Example 3 | Comparative Example 4 | Comparative Example 5 | Comparative Example 6 |
|---|---|---|---|---|---|---|---|---|
| Upper layer | resin | | A-7 | A-1 | A-3 | A-3 | A-3 | A-3 |
| | glass transition temperature (°C) | | 95 | 35 | 80 | 80 | 80 | 80 |
| | thickness (µm) | | 10 | 10 | 10 | 10 | 2 | 35 |
| Lower layer | resin | | B-3 | B-3 | B-1 | B-8 | B-3 | B-3 |
| | glass transition temperature (°C) | | 113 | 113 | 90 | 156 | 113 | 113 |
| Evaluation results | printability of highlight part | 5% | 7 | 7 | 8 | 7 | 7 | 8 |
| | | 3% | 5 | 5 | 6 | 5 | 5 | 7 |
| | | 2% | 4 | 4 | 5 | 4 | 4 | 6 |
| | | 1% | 3 | 3 | 5 | 3 | 3 | 6 |
| | plate-surface adhesiveness | | ○ | × | ○ | ○ | ○ | ○ |
| | plate life | 10000 shots | × | ○○ | ○ | × | × | ○ |
| | | 20000 shots | × | ○○ | ○ | × | × | ○ |

As understood from Table 2, the photosensitive resin compositions of the present invention according to Examples 1 to 13 were excellent in all the gradation print reproducibility of a highlight part, the plate life, and the plate-surface adhesiveness. Comparative Example 1 had poor plate life because the water-soluble or water-dispersible resin A-7 contained in the upper layer had a high glass transition temperature. Comparative Example 2 had a defective-level plate-surface adhesiveness because the water-soluble or water-dispersible resin A-1 contained in the upper layer had a low glass transition temperature. Comparative Example 3 had poor printability of a highlight part because the water-soluble or water-dispersible resin B-1 contained in the lower layer had a low glass transition temperature. Comparative Example 4 had poor plate life because the water-soluble or water-dispersible resin B-8 contained in the lower layer had a high glass transition temperature. Comparative Example 5 had poor plate life because the upper layer had a small thickness. Comparative Example 6 had poor printability of a highlight part because the upper layer had a large thickness.

### Industrial Applicability

According to the photosensitive resin composition of the present invention, it is possible to provide a photosensitive resin printing plate precursor for relief printing, and a printing plate that can each achieve both gradation print reproducibility of a highlight part with 1 to 5% halftone dots and high-level plate life.

## Claims

1. A photosensitive resin printing plate precursor for relief printing,
wherein the photosensitive resin printing plate precursor comprises a support, a photosensitive resin layer, and a cover film stacked in this order, wherein the photosensitive resin layer comprises a lower layer present on a support side and an upper layer present on a cover-film side,
wherein the upper layer is a photosensitive resin layer that contains a water-soluble or water-dispersible resin (A) having a glass transition temperature measured by differential scanning calorimeter of 40 to 90°C, wherein the upper layer has a thickness of 3 to 30 micrometers,
wherein the lower layer is a layer that contains a water-soluble or water-dispersible resin (B) having a glass transition temperature higher than the glass transition temperature of the water-soluble or water-dispersible resin (A) by 5°C or more, and
wherein the glass transition temperature of the resin (B) measured by differential scanning calorimeter is 95 to 135°C.

2. The photosensitive resin printing plate precursor for relief printing according to claim 1, wherein the resin (A) is a polyamide or a polyether urethane urea, and wherein the resin (B) is a polyamide, a polyether urethane urea, or a polyether amide.

3. A printing plate obtained by removing an uncured portion of the photosensitive resin layer from the photosensitive resin printing plate precursor for relief printing according to claim 1 or 2.
